# EUROPEAN PATENT APPLICATION

(11) **EP 2 330 651 A2**
(43) Date of publication of application: **08.06.2011**
(21) Application number: 10193610.2
(22) Date of filing: 03.12.2010
(51) Int. Cl.: H01L 51/50

(54) **Organic light emitting diode device**

(30) Priority: 04.12.2009 KR 20090120029
(71) Applicant: Samsung Mobile Display Co., Ltd., Yongin-city, Gyunggi-do 446-711 (KR)
(72) Inventor: Lee, Sung-Hun, Gyunggi-Do (KR); Tamura, Shinichiro, Gyunggi-Do (KR); Song, Jung-Bae, Gyunggi-Do (KR)
(74) Representative: Gulde Hengelhaupt Ziebig & Schneider

(57) **Abstract**

An organic light emitting diode device is disclosed. The organic light emitting diode device includes a light emitting layer which includes at least two blue light emitting units and at least one orange light emitting unit. Such a device exhibits excellent color characteristic and high luminance and efficiency, as well as a longer life span due to the materials used. In particular, the white light represents color of high color purity after it passes through a color filter.

## Description

The present invention relates to an organic light emitting diode device.

### Description of the Related Technology

Recently, organic light emitting diode (OLED) devices are drawing attention as display devices and as lighting devices.

An organic light emitting diode device generally includes two electrodes and an emission layer interposed therebetween, with electrons injected from one electrode, holes injected from another electrode, and the electrons and the holes are combined in the emission layer to generate excitons which release energy and emit light.

Since the organic light emitting diode device emits light without an additional light source, it has low power consumption, better response speeds, viewing angles, and contrast ratios.

An organic light emitting diode device generally includes a plurality of sub-pixels such as a red sub-pixel, a blue sub-pixel and a green sub-pixel for each pixel, and full colors are represented by combining the sub-pixels.

The red sub-pixel, the blue sub-pixel and the green sub-pixel respectively includes a red emission layer, a blue emission layer and a green emission layer to represent each color. The emission layers may be deposited for the respective sub-pixels by using a fine shadow mask. However, as a display device becomes larger, it becomes more difficult to deposit the emission layers for the respective sub-pixels by using the fine shadow mask.

An alternative is to sequentially deposit a red emission layer, a blue emission layer and a green emission layer in the entire display device by using an open mask to thereby emit white light, and to dispose a color filter where the emitted light passes, to thereby represent red, green and blue for the respective sub-pixels.

In the alternative described above, the stability of white light emission may be deteriorated, because the color characteristic and efficiency of each emission layer may be different according to the characteristics of the emission layer.

### SUMMARY OF CERTAIN INVENTIVE ASPECTS

One aspect is an organic light emitting diode device. The device includes a first electrode, a second electrode facing the first electrode, and a light emitter interposed between the first electrode and the second electrode, where the light emitter includes at least two blue light sub-emitters and at least one orange light sub-emitter.

According toone embodiment, the device includes a first electrode, a first blue emission layer disposed on the first electrode, a first electric charge generation layer disposed on the first blue emission layer, a second blue emission layer disposed on the first electric charge generation layer, a second electric charge generation layer disposed on the second blue emission layer, an orange emission layer disposed on the second electric charge generation layer, and a second electrode disposed on the orange emission layer.

### BRIEF DESCRIPTION OF THE DRAWINGS

FIG. 1 is a cross-sectional view of an organic light emitting diode device according to an exemplary embodiment.
FIG. 2 is a top plan view showing an arrangement of a plurality of pixels of an organic light emitting diode device according to an exemplary embodiment.
FIG. 3 is a cross-sectional view of a structure of an organic light emitting diode device according to an exemplary embodiment.
FIG. 4 is a graph illustrating intensity of an organic light emitting diode device as a function of wavelength according to an exemplary embodiment.
FIG. 5 is a graph illustrating a life-span characteristic of an organic light emitting diode device according to an exemplary embodiment.

### DETAILED DESCRIPTION OF CERTAIN INVENTIVE EMBODIMENTS

This disclosure will be described more fully hereinafter with reference to the accompanying drawings, in which exemplary embodiments are shown.

In the drawings, the thickness of layers, films, panels, regions, etc., are magnified for clarity. Like reference numerals generally designate like elements throughout the specification. It will be understood that when an element such as a layer, film, region, or substrate is referred to as being "on" another element, it can be directly on the other element or intervening elements may also be present.

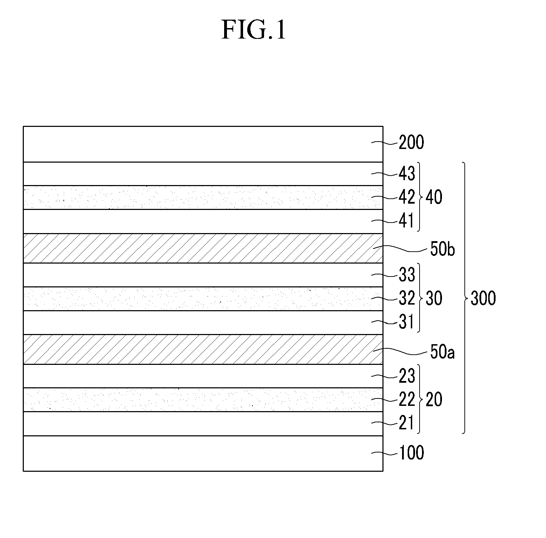

Referring to FIG. 1, an organic light emitting diode device according to an exemplary embodiment is described in detail.

FIG. 1 is a cross-sectional view of an organic light emitting diode device according to an exemplary embodiment.

The organic light emitting diode device according to an exemplary embodiment includes a lower electrode 100 and an upper electrode 200 facing each other, and an organic light emitter 300 interposed between the lower electrode 100 and upper electrode 200.

One of the lower electrode 100 and upper electrode 200 may be a cathode and the other one may be an anode. For example, the lower electrode 100 may be an anode and the upper electrode 200 may be a cathode.

At least one of the lower electrode 100 and upper electrode 200 may be a transparent electrode. When the lower electrode 100 is a transparent electrode, there may be a bottom emission structure emitting light downwards. When the upper electrode 200 is a transparent electrode, there may be a top emission structure emitting light upwards. Also, when both lower electrode 100 and upper electrode 200 are transparent electrodes, light may be emitted both upwards and downwards through emission structures. The transparent electrode may be formed of ITO, IZO or a combination thereof, or it may be formed of aluminum (Al), silver (Ag) or a combination thereof in a thin thickness.

When the lower electrode 100 or the upper electrode 200 is an opaque electrode, it may be formed of an opaque metal such as aluminum (Al), silver (Ag) and the like.

The organic light emitter 300 includes a plurality of light sub-emitters each representing a different color, and white light may be emitted by combining lights emitted from the light sub-emitters.

The organic light emitter 300 includes a first blue light sub-emitter 20, a second blue light sub-emitter 30 and an orange light sub-emitter 40. The organic light emitter 300 also includes an electric charge generation layer 50a formed between the first blue light sub-sub-emitter 20 and the second blue light sub-emitter 30, and an electric charge generation layer 50b formed between the second blue light sub-emitter 30 and the orange light sub-emitter 40. In alternative embodiments, additional blue light sub-emitters and/or orange light sub-emitters may be included. In such embodiments, additional electric charge generation layers may be formed between the additional light sub-emitters.

The first blue light sub-emitter 20 includes a blue emission layer 22 emitting light of a blue wavelength region, and auxiliary layers 21 and 23 disposed respectively in the lower and upper portions of the blue emission layer 22. When the lower electrode 100 is an anode, the auxiliary layer 21 may be at least one of a hole injection layer (HIL) and a hole transport layer, and the auxiliary layer 23 may be at least one of an electron injection layer (EIL) and an electron transport layer (ETL). In alternative embodiments, the auxiliary layer 21 and/or the auxiliary layer 23 may be omitted.

The second blue light sub-emitter 30 includes a blue emission layer 32 emitting light of a blue wavelength region and auxiliary layers 31 and 33 disposed respectively in the lower and upper portions of the blue emission layer 32. When lower electrode 100 is an anode, the auxiliary layer 31 may be at least one of a hole injection layer (HIL) and a hole transport layer, and the auxiliary layer 33 may be at least one of an electron injection layer (EIL) and an electron transport layer (ETL). In alternative embodiments, the auxiliary layer 31 and/or the auxiliary layer 33 may be omitted.

The orange light sub-emitter 40 includes an orange emission layer 42 emitting light of an orange wavelength region and auxiliary layers 41 and 43 disposed respectively in the lower and upper portions of the orange emission layer 42. When the lower electrode 100 is an anode, the auxiliary layer 41 may be at least one of a hole injection layer (HIL) and a hole transport layer, and the auxiliary layer 43 may be at least one of an electron injection layer (EIL) and an electron transport layer (ETL). In alternative embodiments, the auxiliary layer 41 and/or the auxiliary layer 43 may be omitted.

The orange emission layer 42 may be a single layer emitting light of one color, or it may be a stacked layer where two or more layers, each layer emitting a different light, are stacked.

When the orange emission layer 42 is a single layer, the orange emission layer 42 may be formed of a light emitting material emitting orange light of a wavelength region ranging from about 550nm to about 650nm.

The orange emission layer 42 may include one layer including a host material doped with a red light emitting material and a green light emitting material. The host material may be a material that may be used as a host of the green emission layer, and it may be a material whose triplet energy is greater than the triplet energy of the green dopant. The dopant may be a phosphorescent material.

When the orange emission layer 42 is a stacked layer, the orange emission layer 42 may include a red emission layer emitting light of a red wavelength region and a green emission layer emitting light of a green wavelength region stacked therein. In this case, a red emission layer may have a hole transport property, and the green emission layer may have an electron transport property. Examples of the host of the red emission layer may include a triphenylamine derivative, and examples of the host of the green emission layer may include a carbazole derivative including at least one of a triazine group and an oxadiazole group, a spirofluorene derivative, and a combination thereof.

The blue emission layers 22 and 32 may include a fluorescent material, and the orange emission layer 42 may include a phosphorescent material.

The electric charge generation layers 50a and 50b are layers where a pair of electron and hole is generated. The generated holes are transferred to a light sub-emitter on one side and the generated electrons are transferred to a light sub-emitter on another side. For example, when the lower electrode 100 is an anode, and the upper electrode 200 is a cathode, electrons generated in the electric charge generation layer 50a may be transferred to the first blue light sub-emitter 20, and the holes generated in the electric charge generation layer 50a may be transferred to the second blue light sub-emitter 30. Also, the electrons generated in the electric charge generation layer 50b may be transferred to a second blue light sub-emitter 30 and the holes generated in the electric generation layer 50b may be transferred to an orange light sub-emitter 40.

With the electric charge generation layers 50a and 50b formed between the light sub-emitters, it is possible to improve the life-span of the device by improving current efficiency.

As described above, the organic light emitting diode device according to an exemplary embodiment combines emission layers each representing a different color to thereby emit white light. In an exemplary embodiment, white light is emitted by combining at least two blue light sub-emitters and at least one orange light sub-emitter.

The blue emission layer forming a blue light sub-emitter may include a fluorescent material. Generally, a phosphorescent material may be used to achieve an internal quantum efficiency close to about 100%, but since the phosphorescent material emitting blue light has a short life-span, use of the phosphorescent material for the emission layer may shorten the life-span of an organic light emitting diode device. It may be possible to represent stable white color by stacking a plurality of blue emission layers using fluorescent material while achieving the efficiency of phosphorescent material.

As described above, the stable white color may be represented in a color having high color purity and efficiency while passing through color filters.

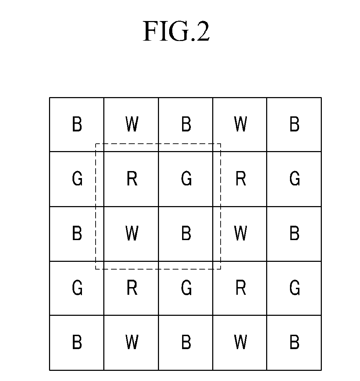

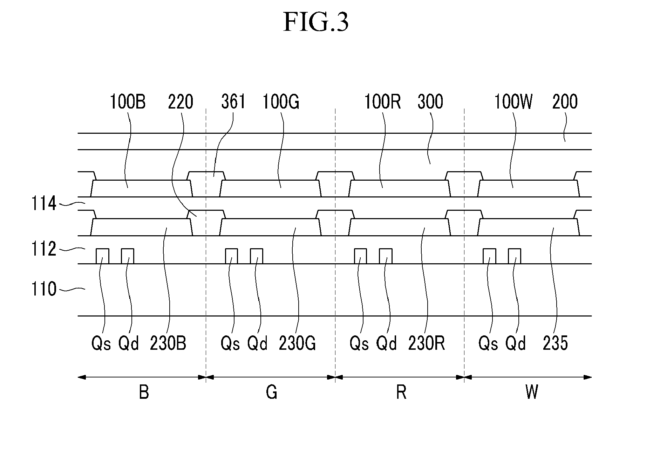

The organic light emitting diode device described above may include a plurality of pixels and each pixel may include a plurality of sub-pixels. This will be described by referring to FIGS. 2 and 3.

FIG. 2 is a top plan view showing an arrangement of a plurality of pixels of an organic light emitting diode device according to an exemplary embodiment. FIG. 3 is a cross-sectional view of a structure of an organic light emitting diode device according to an exemplary embodiment..

Referring to FIG. 2, an organic light emitting diode device according to an exemplary embodiment includes red sub-pixels, R, representing red color, green sub-pixels, G, representing green color, blue sub-pixels, B, representing blue color, and white sub-pixels, W, not representing any color, the sub-pixels arranged alternately.

A red sub-pixel R, a green sub-pixel G and a blue sub-pixel B are primary pixels for representing full colors. A white sub-pixel W may increase the luminance of a device by increasing the degree of light transmission.

The four sub-pixels including the red sub-pixel R, the green sub-pixel G, the blue sub-pixel B and the white sub-pixel W constitute one pixel and the pixel may be repeated along a row and/or column. In alternative embodiments, the arrangement of the pixels may be different.

Referring to FIG. 3, a structure of an organic light emitting diode device including red sub-pixels R, green sub-pixels G, blue sub-pixels B and white sub-pixels W will be described.

A plurality of thin film transistor arrays is arranged on an insulation substrate 110. A thin film transistor array includes a switching thin film transistor, Qs, and a driving thin film transistor, Qd, disposed to be electrically connected for each sub-pixel. Although FIG. 3 exemplarily shows an embodiment of one switching thin film transistor Qs and one driving thin film transistor Qd formed for each sub-pixel, alternative embodiments may include a plurality of one or both transistors formed for each sub-pixel.

A lower insulation layer 112 may be formed on a thin film transistor array. The lower insulation layer 112 includes a plurality of contact holes (not shown) partially exposing the switching thin film transistor Qs and the driving thin film transistor Qd.

A blue filter 230B is formed on a blue sub-pixel (B), and a green filter 230G is formed on a green sub-pixel (G), while a red filter 230R is formed on a red sub-pixel (R) on the lower insulation layer 112. The color filters 230B, 230G, and 230R may be disposed through a scheme of color filter-on array (CoA).

A transparent insulation layer 235 is formed on a white sub-pixel W instead of a color filter to smoothe the step height with a color filter of another sub-pixel. In alternative embodiments, the transparent insulation layer 235 may be omitted.

A light blocker 220 is formed between the blue filter 230B and the green filter 230G, between the green filter 230G and the red filter 230R, and between the red filter 230R and the transparent insulation layer 235. Each of the light blockers 220 may prevent light from leaking between the sub-pixels B, G, R, and W.

An upper insulation layer 114 is formed on the blue filter 230B, the green filter 230G, the red filter 230R, the insulation layer 235 and the light blocker 220. The upper insulation layer 114 includes a plurality of contact holes (not shown) formed therein.

Pixel electrodes 100B, 100G, 100R and 100W are formed on the upper insulation layer 114. The pixel electrodes 100B, 100G, 100R and 100W are electrically connected to the driving thin film transistor Qd through the contact holes (not shown), and The pixel electrodes 100B, 100G, 100R and 100W may function as an anode.

A plurality of insulators 361 are formed on the pixel electrodes 100B, 100G, 100R and 100W to define the sub-pixels, and an organic light emitter 300 may be formed on the pixel electrodes 100B, 100G, 100B, and 100R and the insulator 361.

An organic light emitter 300, as shown in FIG. 1, includes a first blue light sub-emitter 20, a second blue light sub-emitter 30 and an orange light sub-emitter 40. The organic light emitter 300 further includes electric charge generation layers 50a and 50b between the first blue light sub-emitter 20 and the second blue light sub-emitter 30 and between the second blue light sub-emitter 30 and the orange light sub-emitter 40.

In alternative embodiments, the organic light emitting diode device may include a different number of blue light sub-emitters and/or orange light sub-emitters. In such embodiments, an electric charge generation layer may be formed between the light sub-emitters.

The organic light emitter 300 may emit white light by combining lights emitted from the at least two blue light sub-emitters and the orange light sub-emitter.

A common electrode 200 is formed on the organic light emitter 300. The common electrode 200 may be formed throughout the entire surface of the substrate, and it may be a cathode. The common electrode 200 is paired with the pixel electrodes 100B, 100G, 100R and 100W and the common electrode transmits current to the organic light emitter 300.

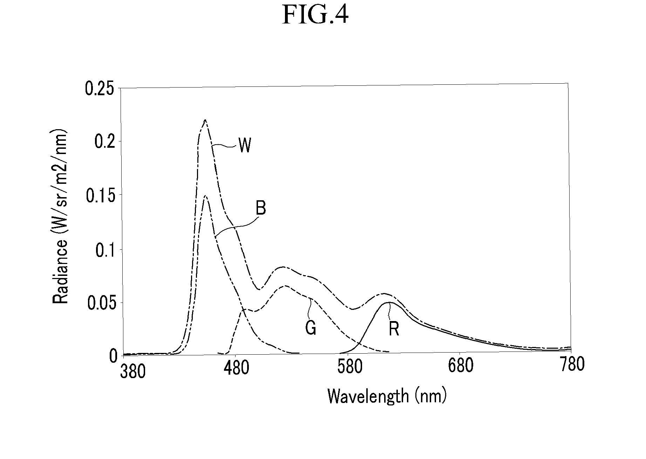

The color characteristic and efficiency of the organic light emitting diode device according to an exemplary embodiment will be described hereafter by referring to FIG. 4 and Table 1 along with FIGS. 1 to 3.

FIG. 4 is a graph illustrating intensity of an organic light emitting diode device as a function of wavelength according to an exemplary embodiment..

In an organic light emitting diode device according to an exemplary embodiment, white light emitted from the emission layer 300 passes through a blue filter 230B, a green filter 230G and a red filter 230R and shows the red peak (R), the green peak (G) and the blue peak (B) shown in FIG. 4.

As shown in FIG. 4, each of the red peak (R), the green peak (G) and the blue peak (B) may have excellent color characteristics in corresponding wavelength regions. Also, the white peak (W) of the white light that does not pass through a color filter also represents white color that is stable and high in luminance.

The color coordinates and luminance are as shown in Table 1 below.

**Table 1**

| 4000 nit | color coordinates | | Cd/m2 | Cd/A | External QE (%) | Power efficiency (lm/W) |
|---|---|---|---|---|---|---|
| | Cx | Cy | | | | |
| W | 0.258 | 0.281 | 4510.0 | 48.1 | 25.04 | 13.7 |
| R | 0.666 | 0.325 | 577.4 | 6.2 | 5.71 | 1.8 |
| G | 0.244 | 0.628 | 2344.7 | 25.0 | 7.07 | 7.1 |
| B | 0.136 | 0.066 | 400.5 | 4.3 | 6.73 | 1.2 |

As shown in FIG. 4 and Table 1 above, an organic light emitting diode device according to an exemplary embodiment has excellent color characteristic and high luminance and efficiency. In particular, the white light represents color of high color purity after it passes through a color filter.

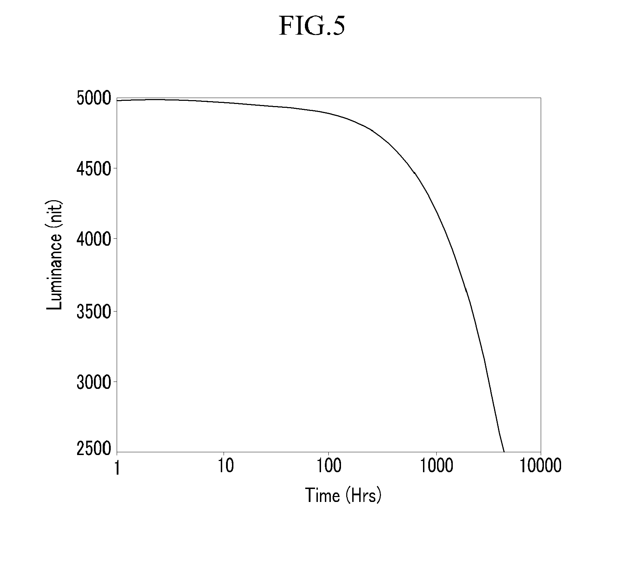

The life-span characteristic is described by referring to FIG. 5.

FIG. 5 is a graph illustrating a life-span characteristic of an organic light emitting diode device according to an exemplary embodiment..

Referring to FIG. 5, it is observed that it takes about 4,400 hours for the luminance of an organic light emitting diode device according to an exemplary embodiment, having a luminance of about 5000 nit during the initial period, to be reduced by half. When the time is converted into an actual condition by applying an accelerating factor of 1.5, a life-span of about 60,000 hours is secured under the condition of about 1,000 nit. Therefore, it may be seen that an organic light emitting diode device according to an exemplary embodiment has a long life-span.

## Claims

1. An organic light emitting diode device comprising
a first electrode (100);
a second electrode (200) facing the first electrode; and
a light emitter (300) interposed between the first electrode and the second electrode;
wherein the light emitter comprises at least two blue light sub-emitters (20, 30) and at least one orange light sub-emitter (40).

2. The organic light emitting diode device of claim 1, wherein the light emitter further comprises a first electric charge generation layer (50a) between the blue light sub-emitters, and a second electric charge generation layer (50b) between the blue light sub-emitter and the orange light sub-emitter.

3. The organic light emitting diode device of claim 1 or 2, wherein the orange light sub-emitter comprises an emission layer (42) emitting light of a wavelength ranging from 550nm to 650nm.

4. The organic light emitting diode device of any one of the preceding claims, wherein the orange light sub-emitter comprises a red emission layer and a green emission layer.

5. The organic light emitting diode device of claim 4, wherein the red emission layer comprises a compound having a hole transport property.

6. The organic light emitting diode device of claim 5, wherein the red emission layer comprises a triphenylamine derivative.

7. The organic light emitting diode device of claim 4, wherein the green emission layer comprises a compound having an electron transport property.

8. The organic light emitting diode device of claim 7, wherein the green emission layer comprises a carbazole derivative having at least one of a triazine group and an oxadiazole group, a spiroffuorene derivative.

9. The organic light emitting diode device of any one of claims 1 through 3, wherein the orange light sub-emitter comprises an emission layer including a host material doped with a red light emitting material and a green light emitting material.

10. The organic light emitting diode device of claim 9, wherein the host material is a material having a greater triplet energy than that of the green light emitting material.

11. The organic light emitting diode device of claim 9, wherein the red light emitting material and the green light emitting material are phosphorescent dopants.

12. The organic light emitting diode device of any one of the preceding claims, wherein the blue light sub-emitter comprises an emission layer (22, 32) including a fluorescent material, and the orange light sub-emitter includes an emission layer including a phosphorescent material.

13. The organic light emitting diode device of any one of the preceding claims, wherein at least one of the blue light sub-emitter and the orange light sub-emitter comprises an auxiliary layer (21, 23, 31, 33, 41, 41).

14. The organic light emitting diode device of any one of the preceding claims, wherein the light emitter emits white light by combining light emitted by the blue light sub-emitter and light emitted by the orange light sub-emitter.

15. The organic light emitting diode device of any one of the preceding claims, wherein the organic light emitting diode device comprises a first, a second and a third sub-pixel, each sub-pixel representing a different color and each comprising a corresponding color filter; a white sub-pixel; and a light emitter commonly formed in the first, second, third and white sub-pixels, wherein the color filters are disposed in a lower or upper portion of the light emitter.
